# EUROPÄISCHE PATENTSCHRIFT

(11) **EP 0 346 801 B1**
(45) Veröffentlichungstag und Bekanntmachung des Hinweises auf die Patenterteilung: **27.12.1996**
(21) Anmeldenummer: 89110602.3
(22) Anmeldetag: 12.06.1989
(51) Int. Cl.: G06F 9/46

(54) **Verfahren und Anordnung zur Ausführung eines Programms in einem heterogenen Mehrrechnersystem**
Method and arrangement for the execution of a programme in a heterogeneous multiprocessor system
Méthode et dispositif pour l'exécution des programmes dans un système hétérogène de multiprocesseur

(30) Priorität: 17.06.1988 US 208318
(43) Veröffentlichungstag der Anmeldung: 20.12.1989
(73) Patentinhaber: SIEMENS AKTIENGESELLSCHAFT, 80333 München (DE)
(72) Erfinder: Wolfson, C. Daniel, Langhorne, PA 19047 (US); Brehm, Frederic W., Mercerville, NJ 08619 (US); Flately, Maura M., Monmouth Junction, NJ 08852 (US); Voorhees, Ellen M., Plainsboro, NJ 08536 (US)

(56) Entgegenhaltungen:
- EP-A- 0 178 235
- EP-A- 0 272 561

## Beschreibung

Die Erfindung bezieht sich auf ein Verfahren und eine Anordnung zur Ausführung eines Programmes in einem heterogenen Mehrrechnersystem.

Mehrrechnersysteme, die Knoten aufweisen, die durch gleichartige Datenverarbeitungseinheiten mit Zugriff zu identischen Mitteln wie periphere Einheiten, Daten und Programmen implementiert sind, werden homogene Systeme genannt. Für ein solches System ist es bekannt, wie Programme von einem Knoten zum anderen transportiert werden und ausgeführt werden. Solche bekannten Systeme können ein auszuführendes Programm entweder unabhängig von dem Programm weitergeben - um eine gleichmäßige Lastverteilung zu erreichen -, oder in Abhängigkeit von Anforderungen des Programmes selbst.

Mehrrechnersysteme, die durch unterschiedliche Datenverarbeitungseinheiten implementiert sind, werden heterogene Systeme genannt. Dabei können die Datenverarbeitungseinheiten Zugriff zu unterschiedlichen Mitteln wie unterschiedliche periphere Einheiten, unterschiedliche Daten oder unterschiedliche Programme haben. Es ist schwieriger, den Transfer von mit Hilfe der Knoten auszuführenden Programmen (im folgenden Organisationsprogramme genannt) in einem heterogenen System durchzuführen als in einem homogenen System, da die Verarbeitungsmöglichkeiten jedes Knotens des heterogenen Systems unterschiedlich zu denen der anderen Knoten sind. Es ist manchmal wünschenswert, daß die Verarbeitung eines solchen Organisationsprogramms in einem solchen System in einem ersten Prozessor beginnt, einem ersten Knoten des Mehrrechenrsystems, und dann auf Anforderung des Programms die Ausführung durch einen zweiten Prozessor weitergeführt wird, einem zweiten Knoten dieses Systems. Dies hat früher dazu geführt, daß das gesamte Programm in getrennte Teile aufgeteilt worden ist, die jeweils von den Prozessoren verschiedener Knoten ausgeführt worden sind. Die verschiedenen Teile des Programms wurden dann getrennt für die Prozessoren eines jeden Knotens programmiert. Während der Ausführung des Programms wird die Steuerung des Ablaufs weitergegeben, z.B. durch einen Aufruf, und die Daten, die dem Programm zugeordnet sind, werden von dem ersten zum zweiten Knoten durch Nachrichtenübertragung weitergeleitet.

Diese Lösung ist verhältnismäßig inflexibel. Eine Änderung des Programms erfordert, daß das gesamte Programmierungsverfahren erneut ausgeführt wird. D.h., das neue Programm muß wiederum in Teile aufgeteilt werden, und die Teile getrennt für die Prozessoren jedes Knotens programmiert werden. Zumindest die Programmierung muß wieder ausgeführt werden, sogar wenn die Änderungen verhältnismäßig gering sind. Wenn aufeinanderfolgende Programmläufe nur geringe Änderungen erfordern, dann muß die erneute Programmierung für jeden Programmlauf ausgeführt werden.

In EP-A-0 178 235 ist ein Verfahren erläutert, bei dem asynchron in einem Mehrrechnersystem eine Nachricht bearbeitet werden kann. Dazu werden diese Nachrichten ,die die Adresse des sendenden Prozessors, die Adresse des empfangenen Prozessors und Informationen enthalten, die angeben, wie jeder Prozessor die mit übertragenen Daten verarbeiten soll an die Prozessoren übertragen. Jeder Prozessor arbeitet unabhängig von den anderen. In Abhängigkeit der Nachricht wird z.B. ein erster Prozessor angesteuert, der die in der Nachricht enthaltene Opertion mit den dort angegebenen Daten durchführt und die Ergebnisse wieder in der Nachricht zusammenfaßt. Diese Nachricht wird dann entsprechend dem Inhalt zu einem weiteren Prozessor übertragen, der eine weitere Operation, die in der Nachricht enthalten ist, mit den dort angegebenen Daten ausführt. Dies wird solange durchgeführt, bis die Nachricht bearbeitet ist. Die Programmierung der Nachricht ist nicht Gegenstand dieser Schrift.

Die der Erfindung zugrundeliegende Aufgabe besteht dagegen darin, ein Verfahren und eine Anordnung zur Ausführung eines Organisationsprogrammes in einem heterogenen Mehrrechnersystem anzugeben, die eine vereinfachte Programmierung erlauben und dabei so flexibel sind, daß bei Änderungen des Programms die Zeit und der Aufwand für die Änderung gering sind.

Diese Aufgabe wird gemäß den Merkmalen des Patentanspruchs 1 gelöst.

Nach den Grundsätzen der vorliegenden Erfindung weist das Verfahren zur Ausführung eines Organisationsprogramms, das Daten und eine Mehrheit von seriell aufeinanderfolgenden Operationen mit diesen Daten beinhaltet, in einem heterogenen Mehrrechnersystem folgende Schritte auf:
1. Es wird die Ausführung des Programms auf einem ersten Prozessor des Mehrrechnersystems begonnen.
2. Es wird die Ausführung des Programms an einen zweiten Prozessor des Mehrrechnersystems weitergegeben und zwar in Abhängigkeit einer der seriell auszuführenden Operationen des Programms. Eine Anordnung zur Realisierung dieser Grundsätze beinhaltet ein heterogenes Mehrrechnersystem zur Ausführung dieses Organisationsprogramms. Das System weist Mittel auf, die die Ausführung des Programms auf einem ersten Prozessor des Mehrrechnersystems starten und Mittel zur Weitergabe der Ausführung des Programms zu einem zweiten Prozessor des Mehrrechnersystems in Abhängigkeit einer der seriell auszuführenden Operationen im Programm.

Als Ausführungsbeispiel sei eine automatisierte Fabrik genannt, die Produktionszellen aufweist, die mehrere Prozessoren mit zugeordneten von den Prozessoren gesteuerte Maschinen enthält. Zur Vereinfachung der folgenden Erläuterungen wird angenommen, daß jede Produktionszelle einen einzigen Prozessor und mehrere zugeordnete von ihm gesteuerte Maschinen aufweist. Jedem Hauptprozessor können weitere Hilfsprozessoren zugeordnet werden. Jede Produktionszelle, die von ihrem Hauptprozessor gesteuert wird und der mehrere Maschinen zugeordnet sind, ist mit den anderen Produktionszellen über ein Netzwerk verbunden. Jede Produktionszelle eines solchen Systems kann als Knoten in einem heterogenen Mehrrechnersystem betrachtet werden. Die Fabrik erzeugt aufeinanderfolgend z.B. Zwischenprodukteinheiten aus Rohstoffen, um daraus Fertigprodukte herzustellen. Die Erzeugung der Einheiten aus Rohstoffen kann als Programm angesehen werden, das durch das in der Fabrik vorhandene Mehrrechnersystem ausgeführt wird. Um Produktionseinheiten zu erzeugen müssen sie durch die Produktionszellen hindurch geleitet werden, da die Produktionszellen die einzelnen Verarbeitungsschritte beim Herstellungsprozess ausführen.

Nach der Erfindung wird ein solches Organisationsprogramm, im folgenden Leitwegprogramm genannt, verwendet, um eine Produktionseinheit zu identifizieren und um alle Informationen aufzunehmen , die notwendig sind, um Fertigprodukte aus Rohstoffen zu erzeugen. Das Leitwegprogramm kann folgende Informationen enthalten: Identifikationsinformation, die sich auf eine Produktionseinheit bezieht; die Folge der Verarbeitungsschritte, die mit der Produktionseinheit ausgeführt werden müssen; die Identifizierung der Produktionszellen und Maschinen, die diese Verarbeitungsschritte ausführen; Parameter, die von den Produktionszellen und Maschinen verwendet werden, um die Verarbeitungsschritte auszuführen; die Ergebnisse der Verarbeitung, die für die Qualitätscontrolle verwendbar sind und als Parameter für nachfolgende Verabeitungsschritte. Das Leitwegprogramm und die Produktionseinheit werden zusammen durch die Fabrik geleitet. Das Leitwegprogramm enthält die Steueroperationen, die den Transfer sowohl von Programm als auch von Produktionseinheit von einer Produktionszelle zur nächsten Produktionszelle steuert, wobei die Auswahl der Produktionszellen mit Hilfe der im Leitwegprogramm gespeicherten Information erfolgt.

Das Leitwegprogramm kann die nächste Maschine bestimmen, die das Leitwegprogramm und die Produktionseinheit auf verschiedenen Wegen erhält. Erstens wird eine bestimmte Maschine ausgewählt, um einen Verarbeitungsschritt in der Folge der Verarbeitungsschritte, die in dem Leitwegprogramm gespeichert sind, auszuführen. Wenn z.B. nur eine Maschine den nächsten Verarbeitungsschritt ausführen kann, dann wird das Leitwegprogramm und die Produktionseinheit dieser Maschine übertragen. Zweitens können unterschiedliche Maschinen festgelegt werden, in Abhängigkeit der Verarbeitungsvergangenheit der Produktionseinheit oder der Eigenschaften dieser Maschinen. In einem Beispiel kann die Produktionseinheit zur nächsten Produktionszelle gesendet werden, die den nächsten Verarbeitungsschritt ausführt, wenn der Verarbeitungsschritt der vorhergehenden Produktionszelle zur Zufriedenheit ausgeführt worden ist. Jedoch wird sie zu einer anderen Produktionszelle gesandt, die den Verarbeitungsschritt wiederholt, wenn die Verarbeitung bei der vorhergehenden Produktionszelle nicht zur Zufriedenheit ausgeführt worden ist. Ein anderes Beispiel beschäftigt sich mit der Halbleiterproduktion unter Verwendung der Fotolithographie. Irgendeiner der vorhandenen Projektionsdrucker kann dazu verwendet werden, um die erste Maske auf einen bestimmten Wafer zu projizieren; danach kann dieser erste Projektionsdrucker verwendet werden, um alle folgenden Masken auf diesen Wafer zu projizieren. Das Leitwegprogramm kann so programmiert sein, daß der Wafer immer wieder zu diesem Projektionsdrucker gesandt wird, der die erste Maske auf den Wafer projiziert hat, um auch die folgenden Masken auf den Wafer zu projizieren. Schließlich kann in einem dritten Beispiel eine Anzahl von Maschinen, von denen jede zur Ausführung des nächsten Verarbeitungsschrittes verwendet werden kann, von dem Leitwegprogamm angesteuert werden. Wenn z.B. jede von vier identischen Maschinen den nächsten Verarbeitungsschritt ausführen könnte, werden diese Maschinen im nächsten Verarbeitungsschritt vom Leitwegprogramm festgelegt. Ein Steuerprogramm (das unabhängig vom Leitwegprogramm arbeitet) legt dann diejenige Maschine der vier Maschinen fest, zu der das Leitwegprogramm und die Produktionseinheit übertragen werden soll. In einem vierten Beispiel kann ein solches Leitwegprogramm die Fähigkeit haben, eine bestimmte Maschine zur Ausführung des nächsten Verarbeitungsschrittes auszuwählen, in Abhängigkeit der Fähigkeiten dieser Maschine. Dabei kann die Verarbeitungsgeschichte der Produktionseinheit berücksichtigt werden.

In einem automatisierten Büro kann jede Büroeinheit einen Personal Computer haben, der von verschiedenen Personen bedient wird und mit den anderen PC's über ein lokales Netzwerk (LAN) verbunden ist. Da veschiedene Personen verschiedene PC's bedienen, kann ein solches System als heterogenes Mehrrechnersystem angesehen werden, selbst dann, wenn alle PC's vom selben Typ mit derselben Ausstattung sind. Es ist auch möglich, daß die PC's von verschiedenen Typen sind und verschiedene periphere Ausstattung und/oder verschiedene Daten und Programme aufweisen. Manchmal wird es notwendig sein, daß ein Dokument von einer vorgegebenen Gruppe von Personen gebilligt wird. Um diesen Zustimmungsprozess durchzuführen, muß das Dokument zu dem PC jeder Person übertragen werden, dessen Zustimmung notwendig ist. Gemäß der vorliegenden Erfindung kann dieses Verfahren als ein Programm angesehen werden, das durch ein Mehrrechnersystem ausgeführt wird. In diesem Fall kann ein Leitwegprogramm geschaffen werden, das das Dokument mit den Daten und Informationen enthält, die notwendig sind, um das Dokument zu den richtigen PC's über das Netzwerk zu übertragen. Hier ist es auch möglich, daß das Leitwegprogramm das Dokument bestimmten Personen zuordnet und/oder Alternativpersonen angibt, von denen einer das Dokument billigen muß. Zusätzlich kann das Leitwegprogramm das Dokument zurückhalten, wenn eine Person nicht verfügbar ist, die dem Dokument zustimmen muß.

Weiterbildungen der Erfindung ergibt sich aus den Unteransprüchen.

Anhand von Ausführungsbeispielen, die in den Figuren dargestellt sind, wird die Erfindung weiter erläutert. Es zeigen:
- Figur 1: ein Blockdiagramm eines heterogenen Mehrrechnersystems bei einer automatisierten Fabrik,
- Figur 2: ein detailierteres Blockschaltbild einer Produktionszelle, die in dem System der Figur 1 verwendet wird,
- Figur 3: ein Blockschaltbild, das die Zuordnung von Herstellungsschritten zu Produktionszellen für ein System der Figur 1 darstellt,
- Figur 4: ein Flußdiagramm eines Leitwegprogramms, das für das System der Figur 1 implementiert worden ist.

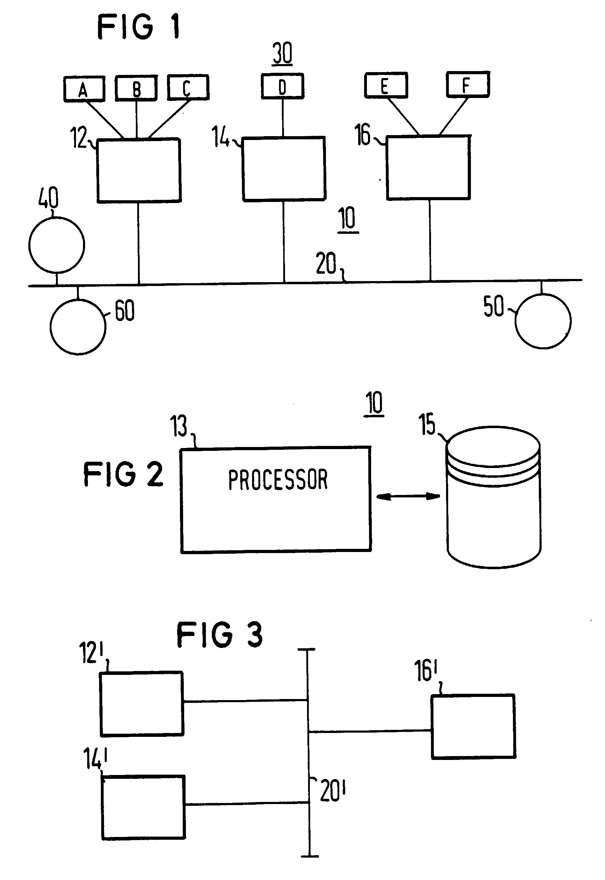

Figur 1 zeigt ein Blockschaltbild eines Mehrrechnersystems das Teil einer automatisierten Fabrik ist. In Figur 1 ist eine Mehrheit von Produktionszellen 10 über ein Netzwerk 20 miteinander verbunden; dieses Netzwerk kann von bekannter Art sein. Jede Produktionszelle ist mit einer Mehrheit von zugeordneten Maschinen 30 verbunden. Ein Vorprozessorknoten 40, ein Endprozessorknoten 50 und ein Steuerknoten 60 sind ebenfalls mit dem Verbindungsnetzwerk 20 verbunden.

Im Betrieb enthält jede Produktionzelle einen Prozessor, der die mit der Produktionszelle verbundenen Maschinen 30 steuert. In Figur 1 steuert z.B. die Produktionszelle 12 die Maschinen A, B und C; die Produktionszelle 14 die Maschine D und die Produktionszelle 16 die Maschinen E und F. In einer automatisierten Fabrik bestehen zwischen diesen Maschinen Beziehungen. Z.B. können sie unmittelbar nebeneinander stehen oder sie können alle vom selben Typ sein oder sie können dieselben Funktionen ausüben.

Ein Leitwegprogramm, das ein Programm ist, das Daten und eine Folge von Funktionen zur Bearbeitung dieser Daten umfaßt, wird von dem Vorprozessorknoten 40 erzeugt. Dieser Knoten 40 kann ein Rechner sein, der vom Produktionspersonal bedient wird. Der Rechner erzeugt z.B. die Identifikationsinformation, Verarbeitungsparameter und Verarbeitungsschritte, die notwendig sind, um eine Einheit eines bestimmtes Produktes aus Rohstoffen zu produzieren. Der Rechner 40 kann eine Bibliothek von oft benutzten, getesteten Standardleitwegprogrammen enthalten, die jeweils einer bestimmten Einheit zugeordnet sind. Die Standardleitwegprogramme können durch das Produktionspersonal modifiziert werden, um ein neues Leitwegprogramm für eine Einheit eines gewünschten Endproduktes zu schaffen, das nur geringfügig unterschiedlich ist von einem Endprodukt, das das Ergebnis der Produktion mit Hilfe eines gegebenen Standardleitwegprogrammes ist. Der Rechner 40 kann zudem eine Bibliothek von getesteten Unterprogrammen enthalten, die kombiniert werden können, um ein neues Leitwegprogramm für ein neues Endprodukt zu schaffen. Gemäß der vorliegenden Erfindung wird das Leitwegprogramm zusammengestellt und als eine komplete Einheit über das Verbindungsnetzwerk zu einer Produktionszelle gesandt, die die Produktionseinheit bearbeiten soll. Diese Produktionseinheit wird ebenfalls zu dieser Produktionszelle gesandt. Dies kann entweder manuell vom Produktionspersonal oder automatisch mit Hilfe einer automatischen Transporteinheit durchgeführt werden. (entsprechend dem Arbeitsvorgang). Wenn das Leitwegprogramm wiederum zusammengestellt wird, um zu einer anderen Produktionszelle übertragen zu werden, dann enthält es nicht nur das Programm und die Daten, sondern auch eine Anzeige über den Stand der Ausführung des Leitwegprogrammes. Vergleichbar einem multi-programming-system kann der Stand der Ausführung gekennzeichnet durch eine Zusammenfassung von Daten, die angeben, welche Anweisung als nächste auszuführen ist, mit den laufenden Werten aller Variablen, die vom Programm definiert werden. Diese Information ist ausreichend, um das Leitwegprogramm bei einer neuen Produktionszelle wieder zu starten.

Der Prozessor der neuen Produktionszelle wertet das Leitwegprogramm wieder aus und führt die Verarbeitungsschritte durch, die dieser neuen Produktionszelle zugeordnet sind. Der Prozessor unter Steuerung durch das Leitwegprogramm veranlaßt die Maschinen, die mit der Produktionszelle verbunden sind, ihre Verarbeitungsschritte auszuführen. Dadurch wird die Produktionseinheit weiter bearbeitet. Der Prozessor veranlaßt weiterhin, daß Meßwerte von der bearbeiteten Einheit genommen werden. Die Meßwerte werden in dem Datenteil des Leitwegprogrammes abgespeichert. Diese Daten können bei der Qualitätskontrolle verwendet werden und/oder als Parameter für die weiteren Verarbeitungsschritte mit Hilfe von anderen Produktionszellen. Das Leitwegprogramm kann weiterhin Verarbeitungsschritte enthalten, die Daten für die Qualitätskontrolle oder nachfolgende Verarbeitungsschritte zusammenfassen und die zu anderen Computersystemen zu deren Benutzung und Analyse übertragen werden. Z.B. kann ein Verarbeitungsschritt im Leitwegprogramm die Ausführung des Leitwegprogrammes bei einer bestimmten Produktionszelle stoppen. Das Leitwegprogramm wird dann neu zusammengefaßt und gemeinsam mit der Produktionseinheit zur nächsten Produktionszelle übertragen. Wenn das Leitwegprogramm und die Produktionseinheit bei der nächsten Produktionszelle ankommen, wird das Leitwegprogramm wieder aufgelöst, das Leitwegprogramm dort wieder ausgewertet, dann ausgeführt und die Produktionseinheit weiter bearbeitet. Diese Folge von Start, Stop, Übertragung, Wiederaufnahme der Ausführung des Leitwegprogrammes wird bei verschiedenen Produktionszellen so lange wiederholt, bis das Endprodukt hergestellt worden ist. Wenn das Endprodukt erzeugt worden ist, können die Daten des vollständigen Leitwegprogrammes in der Endprozessoreinheit 50 gespeichert werden. Die gespeicherten Daten können für die Qualitätskontrolle verwendet werden oder für spätere Analysen.

Wie weiter oben beschrieben kann das Leitwegprogramm festlegen, daß eine aus einer Anzahl von möglichen Maschinen als nächste Maschine das Leitwegprogramm und die Produktionseinheit erhält. Dies ist dann sinnvoll, wenn die Fabrik mehrere identische Maschinen hat. Das Steuerprogramm des Knotens 60 sammelt die Informationen, die die Verfügbarkeit jeder der vorhandenen Maschinen enthält. Das Steuerprogramm im Knoten 60 wählt dann die Maschine aus, die als nächstes verfügbar ist, und veranlasst, daß das Leitwegprogramm und die Produktionseinheit zu der Produktionszelle gesandt wird, die diese Maschine enthält.

Das Leitwegprogramm kann in einer problemorientierten Sprache geschrieben sein, die geeignet ist, im wesentlichen sequentielle Verfahrensschritte darzustellen. D.h. die Bearbeitung einer Einheit erfolgt im wesentlichen als eine Folge von nacheinander auszuführenden Verarbeitungsschritten. Die Sprache kann benutzt werden, um die Datenstruktur des Leitwegprogrammes und die Folge von auszuführenden Verarbeitungssschritten bezogen auf die Einheit und die Daten zu definieren. Da der Verarbeitungsprozess im wesentlichen als ein Programm angesehen werden kann, das auf einem Mehrrechnersystem ausgeführt wird, können Software Engineering Techniken verwendet werden, um den Entwurf des Leitwegprogrammes zu erleichtern. Z.B. können die Folgen von Operationen festlegende Befehle ( z.B. IF, CASE, WHILE, UNTIL) im Leitwegprogramm enthalten sein. Die Sprache, die zur Implementierung des Leitwegprogrammes verwendet wird, wird von jeder Produktionszelle übersetzt. Auf diese Weise wird die Ausführung des Leitwegprogrammes für die Produktionszellen transparent und die Prozessoren können es ausführen. Ein Interpretierer wird somit für jeden Prozessor in jeder Produktionszelle der Fabrik entworfen und implementiert. Der Interpretierer muß fähig sein, die Standardanweisungen auszuführen, die in der zur Programmierung des Leitwegprogramms verwendeten Sprache enthalten sind. Diese Answeisungen können die Steuerung von und Datensammlung bei den Produktionszellen und deren Abspeicherung im Datenteil des Leitwegprogrammes veranlassen. Weiterhin muß der Interpretierer Anweisungen auslegen, um zur Ausführung des Leitwegprogrammes in einer Produktionszelle das Leitwegprogramm anzuhalten, wieder zusammenzufassen und zur nächsten Produktionszelle zu senden.

Die Figur 2 zeigt ein ausführlicheres Blockdiagramm einer Produktionszelle 10 gemäß Figur 1. Die Produktionszelle 10 besteht aus einem Prozessor 13, der z.B. mit einen Plattenspeicher 15 verbunden ist. Der Prozessor 13 umfaßt eine Datenverarbeitungseinheit (CPU), Schaltkreise zur Verbindung des Prozessors mit den zugeordneten Maschinen dieser Produktionszelle, Programmspeicher, z.B. einen Zufallszugriffspeicher (RAM). Der Speicher 15 kann die folgenden Softwareroutinen enthalten:
1. Den Interpretierer für die Sprache, in der das Leitwegprogramm implementiert ist;
2. Steuerroutinen für die Maschinen der Produktionszelle;
3. Routinen zum Zusammenfassen der Verfahrensschrittergebnisse der Maschinen, um sie im Leitwegprogramm abzuspeichern,
4. Routinen zur Planung der nächsten Tätigkeit dieser Produktionszelle z.B. um die Folge von Operationen der Maschinen dieser Produktionszelle festzulegen;
5. Routinen, um den Empfang des Leitwegprogramms von der vorhergehenden Produktionszelle festzulegen, um das Leitwegprogramm auszuwerten und wieder zusammenzufassen und um es zur nächsten Produktionszelle zu übertragen. Der Speicher 15 speichert zudem die Eigenschaften der Maschinen und Programme für oft verwendete Folgen von Maschinenoperationen. Wenn der Prozessor mit seiner Arbeit beginnt, werden diese Routinen vom Speicher 15 in den RAM-Speicher des Prozessors geladen.

Wenn ein Leitwegprogramm von einer Produktionszelle zur nächsten übertragen worden ist, dann wird die Statusinformation herausgefiltert. Anschließend wird das Leitwegprogramm in den Status gebracht, den es hatte, als die Ausführung bei der vorhergehenden Produktionszelle gestoppt worden ist. Die Ausführung des Leitwegprogrammes wird dann aufgenommen. Der Interpretierer führt Befehle des Leitwegprogrammes aus, greift auf die Routinen zu, die notwendig sind, um die Maschinen zu steuern und um die Produktionsergebnisse zu sammeln. Wenn ein Befehl den Transfer des Leitwegprogrammes zu einer anderen Produktionszelle erfordert, dann wird der laufende Zustand des Leitwegprogrammes im Programm vermerkt und es wird zur nächsten ausgewählten Produktionszelle gesandt.

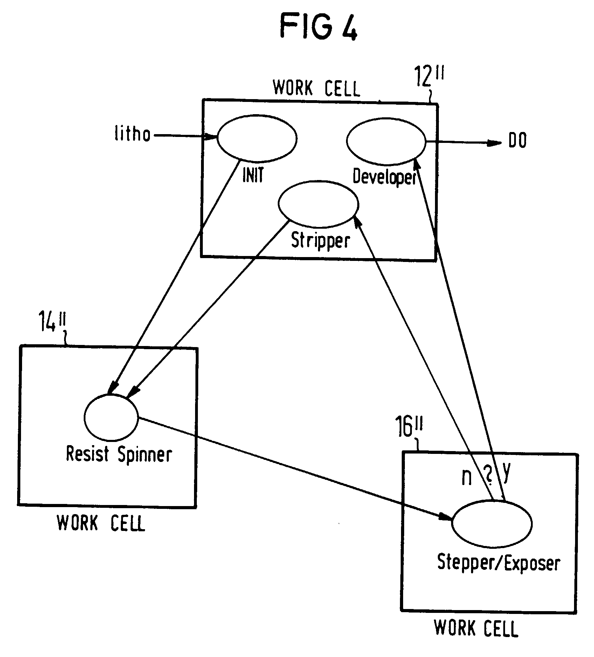

Die Ausführung eines Leitwegprogrammes, daß im Produktionsprozess für einen Halbleiterbaustein verwendbar ist, und zwar für den photolithographischen Teil des Prozesses, wird im folgenden erläutert: Figur 3 zeigt den Ausschnitt des Herstellungsprozesses, der diesen Teil der Halbleiterfertigung betrifft. In Figur 3 sind drei Produktionszellen 12′ ,14′ ,16′, gezeigt, die den beschriebenen Fertigungsschritt ausführen und die über ein Netzwerk 20′ miteinander verbunden sind. In der Produktionszelle 12′ werden - veranlaßt durch das Leitwegprogramm - folgende Verfahrensschritte ausgeführt: Ein vorher belichteter Fotolack wird entwickelt, eine unkorrekt aufgebrachte belichtete Maske wird entfernt. In der Produktionszelle 14′ wird Fotolack auf den Wafer aufgebracht. In der Produktionszelle 16′ wird der vorher aufgebrachte Fotolack belichtet. Das Netzwerk 20′ kann auch mit anderen Produktionszellen, die nicht gezeigt sind, verbunden sein. Wie oben angegeben, wird ein Leitwegprogramm zwischen den Produktionszellen übertragen, die diese Verarbeitungsschritte ausführen. Diese Tätigkeit des Leitwegprogrammes wird anhand der Figur 4 weiter erläutert.

Figur 4 zeigt ein Flußdiagramm, das den Pfad des Leitwegprogrammes durch die zugeordneten Produktionszellen zeigt. Durch die folgende Beschreibung wird es verständlich, daß die Produktionseinheit immer zusammen mit dem Leitwegprogramm übertragen wird.

In Figur 4 wird das Leitwegprogramm "litho" genannt und zum Start des Prozesses in die Produktionszelle 12˝ übertragen (über ein nicht dargestelltes Netzwerk). Zunächst löst die Produktionszelle 12˝ das Leitwegprogramm "litho" auf. Nachdem einige interne Variablen im Leitwegprogramm gesetzt worden sind, fügt die Produktionszelle 12˝ das Leitwegprogramm "litho" wieder zusammen und überträgt es mit seinem laufenden Ausführungsstatus zu der Produktionszelle 14˝,die Photolack aufbringt. Nachdem dort das Leitwegprogramm "litho" ausgewertet worden ist, wird der Operationsteil des Leitwegprogrammes ausgeführt, der die Aufbringung des Photolackes auf dem Wafer veranlasst. Wenn dieser Prozess beendet ist, wird das Leitwegprogramm wieder neu gepackt und in die Produktionszelle 16˝ übertragen, in der der Belichtungsprozess ausgeführt wird. Nachdem in der Produktionszelle 16˝ das Leitwegprogramm wieder aufgelöst worden ist, belichtet eine Belichtungsmaschine den vorher aufgebrachten Photolack auf dem Wafer, um die nächste Maskenschicht auf dem Wafer zu erzeugen. Als Teil des Belichtungsprozesses werden Daten gesammelt, die die Genauigkeit der Belichtung angeben. Diese Daten können entweder vom Produktionspersonal gesammelt werden oder durch eine Einrichtung an der Maschine selbst gemessen werden. Die Daten können dazu verwendet werden, um weitere Verarbeitungsschritte der Produktionseinheit festzulegen. Im dargestellten Beispiel wird eine Ja oder Nein Entscheidung vom Produktionspersonal abgefragt. Dementsprechend wird eine genauere Information, die sich auf den Verarbeitungsschritt bezieht, vom Verarbeitungspersonal verlangt oder numerische Daten, die den Verarbeitungsschritt betreffen, werden von der Maschine abgefragt. Die numerischen Daten können dann mit vorgegebenen Sollwerten verglichen werden, um die weitere Verarbeitung festzulegen.

In Figur 4 wird das Leitwegprogramm wieder gepackt und zur Ausführung von einem von zwei möglichen Prozessen in die Produktionszelle 12˝ übersandt. Wenn die Belichtung korrekt gemacht worden war, dann wird das Leitwegprogramm wieder gepackt und der Entwicklungsschritt in der Produktionszelle 12˝ durchgeführt. Nach diesem Schritt wird das Leitwegprogramm zu weiteren Produktionszellen für die weitere Verarbeitung gesandt (am Ausgang DO).

Wenn die Belichtung nicht korrekt gemacht worden ist, dann wird das Leitwegprogramm wieder gepackt und in der Produktionszelle 12˝ die Schicht beseitigt. Nach der Beseitigung wird dann der Wafer für eine neue Schicht von Photolack vorbereitet. Das Leitwegprogramm wird wieder gepackt und zur Produktionszelle 14˝,16˝ übergesandt, so daß dort die zugeordneten Verarbeitungsschritte wiederholt werden können. Die Anzahl der Wiederholungen kann begrenzt sein durch eine entsprechende Information im Leitwegprogramm, z.B. kann nach zwei Wiederholungen der Wafer als Ausschuß behandelt werden.

Wenn das Leitwegprogramm vollständig ausgeführt worden ist, dann veranlasst ein Endbefehl im Leitwegprogramm, daß die Ausführung im System gestoppt wird und das Leitwegprogramm zu den Knoten 50 der Figur 1 übertragen wird. Dort kann das Programm in einem Archivspeicher gespeichert werden. Die Daten im Leitwegprogramm können weiterverarbeitet werden oder zu einem anderen Rechnersystem übertragen werden.

Das Verfahren und die Anordnung zur Ausführung des Programmes in einem heterogenen Mehrrechnersystem ist beschrieben worden im Bezug zu einer automatischen Fabrik. Selbstverständlich können dieselben Grundsätze bei einem automatisierten Bürosystem verwendet werden oder einem ähnlichen System.

## Patentansprüche

1. Verfahren zur Ausführung eines in einer problemorientierten Sprache programmierten Programms in einem heterogenen Mehrrechnersystem,
- bei dem das Programm Daten und eine Mehrheit von aufeinanderfolgenden Operationen zur Verarbeitung dieser Daten auf unterschiedlichen Prozessoren enthält,
- bei dem die Prozessoren des Mehrrechnersystems jeweils einen Interpretierer aufweisen, der das Programm entsprechend dem Betriebssystemen der Prozessoren so aufbereitet, daß es vom zugeordneten Prozessor ausgeführt werden kann,
- bei dem das Programm einem ersten Prozessor des Mehrrechnersystems zur Ausführung zugeführt wird und der Interpretierer dieses Prozessors das Programm entsprechend dem Betriebssystemen des Prozessors so umgestaltet, daß dieser Prozessor eine erste Operation ausführt,
- bei dem wahlweise der Interpretierer Ergebnisse der ersten Operation in das Programm einfügt und das Programm wahlweise an einen zweiten Prozessor weiterleitet,
- bei dem der Interpretierer des zweiten Prozessors bei Zusendung des Programms das Programm zur Ausführung einer weiteren Operation entsprechend dem Betriebssystem des zugeordneten Prozessors aufbereitet, sodaß der zweite Prozessor die Operation ausführen kann,
- bei dem wahlweise der Interpretierer des zweiten Prozessors die Ergebnisse der Verarbeitung in das Programms einfügt und wahlweise das Progamm an einen dritten Prozessor überträgt,
- bei dem dies solange durchgeführt wird, bis das Programm bearbeitet ist.

2. Verfahren nach Anspruch 1,
- bei dem bei mehreren identischen Prozessoren mit Hilfe eines Steuerprogramms einer der identischen Prozessoren anhand von Statusinformationen der Prozessoren ausgewählt und diesem Prozessor das Programm zugeführt wird.

3. Verfahren nach Anspruch 1 oder 2,
- bei dem das Programm allen oder einem Teil der Prozessoren zugesandt wird.

4. Verfahren nach einem der vorhergehenden Ansprüche,
- bei dem das Mehrrechnersystem eine automatisierte Fabrik ist, bei der jeder Prozessor eine Produktionszelle in dieser Fabrik darstellt.

5. Verfahren nach einem der Ansprüche 1 bis 3,
- bei dem das Mehrrechnersystem in einem automatisierten Büro implementiert ist, in dem jeder Prozessor des Mehrrechhnersystems ein Arbeitsbereich in diesem Büro darstellt.

6. Anordnung zur Durchführung des Verfahrens nach Anspruch 1 mit folgenden Merkmalen:
- es sind Mittel vorgesehen, um die Ausführung des Programms im ersten Prozessor des Mehrrechnersystems zu starten,
- es sind Mittel vorgesehen, um die Ausführung des Programms beim ersten Prozessor in Abhängigkeit einer Operation zu stoppen,
- es sind Mittel vorgesehen, um die weitere Ausführung des Programms einem anderen Rechner des Mehrrechnersystems in Abhängigkeit der Operationen in dem Programm zu übertragen.

7. Anordnung nach Anspruch 6,
- bei dem jeder Prozessor einen Interpretierer enthält, der das Programm interpretiert.

8. Anordnung nach Anspruch 7,
- bei der mehrere identische Prozessoren vorgesehen sind, bei der in einem Knoten (60) Statusinformation dieser identischen Prozessoren gesammelt ist,
- bei der der Knoten durch ein Steuerprogramm unter Verwendung dieser Statusinformation einen der Prozessoren auswählt und diesem das Programm zuführt.

## Claims

1. Method for the execution of a program in a heterogeneous multi-processor system programmed in a problem-oriented language,
- in which the program contains data and a plurality of successive operations for the processing of this data on different processors,
- in which the processors of the multi-processor system in each case have an interpreter, which preprocesses the program in a way corresponding to the operating systems of the processors such that it can be executed by the assigned processor,
- in which the program is fed to a first processor of the multi-processor system for execution and the interpreter of this processor reorganizes the program in a way corresponding to the operating system of the processor such that this processor executes a first operation,
- in which the interpreter optionally inserts results of the first operation into the program and optionally passes on the program to a second processor,
- in which, if the program is sent, the interpreter of the second processor preprocesses the program for the execution of a further operation in a way corresponding to the operating system of the assigned processor, so that the second processor can execute the operation,
- in which the interpreter of the second processor optionally inserts the results of the processing into the program and optionally transfers the program to a third processor,
- in which this keeps being carried out until the program is processed.

2. Method according to Claim 1,
- in which, given a plurality of identical processors, one of the identical processors is selected with the aid of a control program on the basis of status information of the processors and the program is fed to this processor.

3. Method according to Claim 1 or 2,
- in which the program is sent to all or some of the processors.

4. Method according to one of the preceding claims,
- in which the multi-processor system is an automated factory in which each processor represents a production cell in this factory.

5. Method according to one of Claims 1 to 3,
- in which the multi-processor system is implemented in an automated office in which each processor of the multi-processor system represents a work area in this office.

6. Arrangement for carrying out the method according to Claim 1, having the following features:
- means are provided to start the execution of the program in the first processor of the multi-processor system,
- means are provided to stop the execution of the program in the case of the first processor in dependence on an operation,
- means are provided to transfer the further execution of the program to another processor of the multi-processor system in dependence on the operations in the program.

7. Arrangement according to Claim 6,
- in which each processor contains an interpreter which interprets the program.

8. Arrangement according to Claim 7,
- in which a plurality of identical processors are provided, status information of these identical processors being collected at a node (60),
- in which the node selects one of the processors by a control program, using this status information, and feeds the program to this processor.

## Revendications

1. Méthode pour l'exécution d'un programme programmé dans un langage d'application spécifique dans un système hétérogène de multiprocesseur,
- dans laquelle le programme contient des données et une pluralité d'opérations se succédant pour le traitement de ces données dans différents processeurs,
- dans laquelle les processeurs du système de multiprocesseur comprennent chacun, respectivement, un programme d'interprétation qui prépare le programme conformément au système d'exploitation des processeurs, de manière à ce qu'il puisse être exécuté par le processeur associé,
- dans laquelle le programme est amené à un premier processeur du système de multiprocesseur pour l'exécution et le programme d'interprétation de ce processeur transforme le programme conformément au système d'exploitation du processeur, de manière à ce que ce processeur exécute une première opération,
- dans laquelle le programme d'interprétation inclut, facultativement, des résultats de la première opération dans le programme et transmet le programme, facultativement, à un deuxième processeur,
- dans laquelle, lors de l'envoi du programme, le programme d'interprétation du deuxième processeur prépare le programme pour l'exécution d'une autre opération conformément au système d'exploitation du processeur associé, de manière à ce que le deuxième processeur puisse exécuter l'opération,
- dans laquelle le programme d'interprétation du deuxième processeur inclut, facultativement, les résultats de la transformation dans le programme et transmet, facultativement, le programme à un troisième processeur,
- dans laquelle cela est exécuté jusqu'à ce que le programme soit traité.

2. Méthode selon la revendication 1,
- dans laquelle, lorsqu'il y a plusieurs processeurs identiques, un des processeurs identiques est sélectionné à l'aide d'un programme de commande en se basant sur des informations de statut des processeurs et le programme est amené à ce processeur.

3. Méthode selon la revendication 1 ou 2,
- dans laquelle le programme est envoyé à tous les processeurs ou à une partie des processeurs.

4. Méthode selon l'une des revendications précédentes,
- dans laquelle le système de multiprocesseur est une usine automatisée dans laquelle chaque processeur représente une cellule de production dans cette usine.

5. Méthode selon l'une des revendications 1 à 3,
- dans laquelle le système de multiprocesseur est mis en oeuvre dans un bureau automatisé dans lequel chaque processeur du système de multiprocesseur représente un domaine de travail dans ce bureau.

6. Dispositif pour l'exécution de la méthode selon la revendication 1, présentant les caractéristiques suivantes :
- on prévoit des moyens pour démarrer l'exécution du programme dans le premier processeur du système de multiprocesseur,
- on prévoit des moyens pour stopper l'exécution du programme dans le premier processeur en fonction d'une opération,
- on prévoit des moyens pour transférer la suite de l'exécution du programme à un autre ordinateur du système de multiprocesseur en fonction des opérations dans le programme.

7. Dispositif selon la revendication 6,
- dans lequel chaque processeur contient un programme d'interprétation qui interprète le programme.

8. Dispositif selon la revendication 7,
- dans lequel on prévoit plusieurs processeurs identiques, dans lequel une information de statut de ces processeurs identiques est collectée dans un noeud (60),
- dans lequel le noeud sélectionne un des processeurs à l'aide d'un programme de commande en utilisant cette information de statut et amène le programme à ce processeur.
